# EUROPÄISCHE PATENTSCHRIFT

(11) **EP 2 501 841 B1**
(45) Veröffentlichungstag und Bekanntmachung des Hinweises auf die Patenterteilung: **25.10.2017**
(21) Anmeldenummer: 10781639.9
(22) Anmeldetag: 10.11.2010
(51) Int. Cl.: C23C 18/14, C23C 18/12, H01L 21/02, C08G 77/60, C09D 183/16

(54) **VERFAHREN ZUR HERSTELLUNG VON SILICIUMSCHICHTEN**
METHOD FOR PRODUCING SILICON LAYERS
PROCÉDÉ DE PRODUCTION DE COUCHES DE SILICIUM

(30) Priorität: 18.11.2009 DE 102009053806
(43) Veröffentlichungstag der Anmeldung: 26.09.2012
(73) Patentinhaber: Evonik Degussa GmbH, 45128 Essen (DE)
(72) Erfinder: WIEBER, Stephan, 76137 Karlsruhe (DE); PATZ, Matthias, 46240 Bottrop (DE); CARIUS, Reinhard, 52428 Jülich (DE); BRONGER, Torsten, 52064 Aachen (DE); CÖLLE, Michael, 45721 Haltern am See (DE)
(86) Internationale Anmeldenummer: PCT/EP2010/067207
(87) Internationale Veröffentlichungsnummer: WO 2011/061106

(56) Entgegenhaltungen:
- EP-A1- 1 087 428
- JP-A- 7 267 621
- US-A- 5 700 400
- US-A- 5 866 471
- US-A1- 2004 255 848
- US-A1- 2006 185 712
- US-A1- 2008 085 373
- BRINZA M ET AL: "Optoelectronic properties of hot-wire silicon layers deposited at 100<o>C", JOURNAL OF NON-CRYSTALLINE SOLIDS, NORTH-HOLLAND PHYSICS PUBLISHING. AMSTERDAM, NL, vol. 354, no. 19-25, 1 May 2008 (2008-05-01), pages 2248-2252, XP022621456, ISSN: 0022-3093, DOI: 10.1016/J.JNONCRYSOL.2007.10.043 [retrieved on 2008-03-14]

## Beschreibung

Die Erfindung betrifft ein Flüssigphasen-Verfahren zur Herstellung von Siliciumschichten aus höheren Silanen, die aus nicht-cyclischen Silanen herstellbar sind.

Die Synthese von Siliciumschichten ist von großer Bedeutung für die Halbleiterindustrie, insbesondere für die Herstellung elektronischer oder optoelektronischer Bauteilschichten, z.B. für den Einsatz in Solarzellen, Photodioden und Transistoren.

Dabei lassen sich Siliciumschichten prinzipiell über verschiedene Verfahren herstellen. Von diesen haben jedoch Sputtertechniken den Nachteil, dass sie im Hochvakuum durchgeführt werden müssen. Gasphasenabscheidungsprozesse haben weiterhin den Nachteil, dass sie i) im Falle einer thermischen Reaktionsführung den Einsatz sehr hoher Temperaturen oder ii) im Falle des Einbringens der erforderlichen Energie für die Zersetzung des Precursors in Form von elektromagnetischer Strahlung hohe Energiedichten erfordern. In beiden Fällen ist es nur mit höchstem apparativem Aufwand möglich, die zur Zersetzung des Precursors benötigte Energie gezielt und einheitlich einzubringen. Da auch die anderen Verfahren zur Herstellung von Siliciumschichten nachteilig sind, werden somit Siliciumschichten bevorzugt über Abscheidungen aus der flüssigen Phase gebildet.

Bei derartigen Flüssigphasen-Verfahren zur Herstellung von Siliciumschichten werden flüssige Edukte (ggf. fungierend als Lösemittel für weitere Additive und/oder Dotierstoffe) oder flüssige Lösungen enthaltend die (selbst flüssigen oder festen) Edukte (und ggf. weitere Additive und/oder Dotierstoffe) auf das zu beschichtende Substrat aufgebracht und nachfolgend thermisch und/oder mit elektromagnetischer Strahlung zu einer Siliciumschicht konvertiert.

Bevorzugt einsetzbare Edukte sind dabei Hydridosilane. Diese Verbindungen bestehen im Wesentlichen aus Silicium- und Wasserstoffatomen und haben den Vorteil, dass sie bei Konvertierung zu abgeschiedenem Silicium (mit ggf. einem für die elektronischen Eigenschaften förderlichen Rest-Wasserstoffanteil) und gasförmigem Wasserstoff reagieren.

Zum Stand der Technik gehören dabei vor allem Flüssigphasen-Verfahren zur Herstellung von Siliciumschichten aus cyclischen Silanen (inklusive Spiro-Verbindungen) oder aus höheren Silanen (Oligomeren) die aus cyclischen Silanen (inklusive Spiro-Verbindungen) herstellbar sind.

So beschreibt zum Beispiel EP 1 134 224 A2 ein Verfahren zur Herstellung von Siliciumfilmen auf der Oberfläche eines Substrates, bei dem eine Lösung enthaltend Cyclopentasilan und Silylcyclopentasilan oder Spiro[4.4]nonasilan unter Bildung eines Beschichtungsfilmes auf eine Substratoberfläche aufgebracht werden und der Beschichtungsfilm anschließend durch Erhitzen in einen Siliciumfilm umgewandelt wird. Dabei wurde festgestellt, dass Silylcyclopentasilan und Spiro[4.4]nonasilan die Eigenschaft haben, als Radikal-Polymerisations-Initiatoren für Cyclopentasilan zu fungieren bzw. selbst ringöffnend zu polymerisieren, so dass Silylcyclopentasilan und Spiro[4.4]nonasilan bzw. deren Gemische mit Cyclopentasilan, ggf. nach vorheriger Bestrahlung mit UV-Licht, zur Herstellung von Siliciumschichten über thermische Prozesse (thermische Konvertierung) eingesetzt werden können. Die beschriebenen thermischen Konvertierungszeiten betragen 30 s bis 30 Minuten bei Temperaturen von mehr als 300 °C, bevorzugt 400 - 500 °C.

Durch die ringöffnende Polymerisation der eingesetzten cyclischen Verbindungen entstehen im Wesentlichen lineare Oligomere. Diese im Wesentlichen linearen Oligomere sind jedoch nachteilig für die Siliciumschichtherstellung, da sie nur in einem sehr engen Molmassenbereich eingesetzt werden können: Ein zu kleines Molekulargewicht führt zu schlechter bzw. keiner Benetzung. Ein zu großes Molekulargewicht führt zu nicht stabilen Zusammensetzungen, aus denen zu große Oligomere ausfallen und mit denen keine gute Benetzung bzw. homogene Schichten erhalten werden können.

Im Stand der Technik werden neben den genannten Flüssigphasen-Verfahren zur Herstellung von Siliciumschichten aus cyclischen Silanen bzw. aus diesen herstellbaren höheren Silanen (Oligomeren) auch Flüssigphasen-Verfahren zur Herstellung von Siliciumschichten aus linearen Silanen (ggf. in Kombination mit cyclischen Silanen) bzw. jeweils aus diesen herstellbaren höheren Silanen (Oligomeren) beschrieben.

So wird in US 2006/0185712 A1 ein Verfahren zur Herstellung von Siliciumschichten auf der Oberfläche von Substraten beschrieben, bei dem eine flüssige Silanzusammensetzung aus einem Silan der Formel SiₙRₘ mit n größer-gleich 3 und m = n bis (2n+2) und unabhängig voneinander Wasserstoff- oder Halogenatom oder Alkyl- oder Phenylgruppe, mit der Maßgabe, dass wenn alle R = H sind und m = 2n ist, n eine Zahl größer-gleich 7 ist, und eine Silanverbindung ausgewählt aus Cyclopentasilan, Cyclohexasilan und Silylcyclopentasilan, auf das Substrat aufgebracht und mit Wärme und/oder Licht behandelt wird. Im Beispiel wird das Silan der Formel SiₙRₘ durch ringöffnende Polymerisation von Cyclopentasilan erzeugt. Die Behandlung erfolgte bei 200 °C für 10 Minuten und anschließend bei 500 °C für 15 Minuten.

So beschreibt JP 07-267621 A ein Verfahren zur thermischen Herstellung einer Siliciumschicht auf einem Substrat, bei dem flüssige Silane der Formel SiₘH₂ₘ₊₂ (mit m ≥ 5) oder SiₙH₂ₙ (mit n ≥ 4) eingesetzt werden. Die nach dem dort beschriebenen Verfahren herstellbaren Siliciumschichten können amorph oder polykristallin sein. Als Konvertierungstemperaturen sind dort Temperaturen von 200 - 550 °C zur Erzielung von amorphen Siliciumschichten beschrieben. Oberhalb von 550 °C sollen polykristalline Schichten resultieren. Unterhalb von 200 °C sei die Umwandlung zu Silicium nicht vollständig. In den Beispielen werden Konvertierungszeiten von 30 Minuten (300 °c; 350 °C; 450 °C) und 60 Minuten (700 °C) beschrieben.

Auch JP 09-045922 A beschreibt ein Verfahren zur Herstellung polykristalliner Siliciumschichten auf einem Substrat, bei dem Silane der Formel SiₘH₂ₘ₊₂ (mit m ≥ 5) oder SiₙH₂ₙ (mit n ≥ 4) für Bestrahlungsprozesse eingesetzt werden. Als Konvertierungstemperaturen sind dort Temperaturen von 200 - 550 °C beschrieben. Unterhalb von 200 °C sei die Umwandlung zu Silicium nicht vollständig. In den Beispielen werden Konvertierungszeiten von 30 Minuten im Wasserstoffplasma (350 °C; 480 °C) beschrieben.

US 5,866,471 A beschreibt u.a. den Einsatz linearer oder cyclischer Hydridosilane und silylgruppensubstituerter linearer oder cyclischer Hydridosilane, die thermisch in einen Halbleiterfilm zersetzt werden können. Die genannten Stoffe sind bei Raumtemperatur fest, löslich in organischen Lösemitteln und weisen vorzugsweise einen Polymerisationsgrad von 3 - 10.000, bevorzugt 5 - 30 auf. Sie werden weiterhin bevorzugt zwischen 200 und 700 °C thermisch zersetzt, wobei die Härtungszeiten zwischen 10 Minuten und 10 Stunden liegen.

In US 5,700,400 A werden Verfahren zur Herstellung halbleitender Materialien beschrieben, bei denen Hydrosilanmonomere einer dehydrogenierenden Kondensation unterzogen werden, deren Zwischenprodukt nachfolgend thermisch zersetzt wird. Bei dem Hydrosilanmonomer kann es sich um ein Monosilan-, Disilan- oder Trisilan-Derivat handeln. Die thermische Zersetzung erfolgt bei Temperaturen von 200 - 1000 °C, bevorzugt 200 - 700 °C. Dabei liegen die in den Beispielen angegebenen Konvertierungszeiten zwischen einer Stunde (700 °C) und 24 Stunden (200 °C).

EP 1 085 560 A1 lehrt, cyclische Silanverbindungen der Formel SiₙXₘ (mit n ≥ 5 und m = n, 2n-2 oder 2n) und/oder modifizierte Silane der Formel SiₐX_{b}Y_{c} (mit a ≥ 3, b = a bis 2a+c+2, c = 1 bis a) zur Herstellung von Siliciumfilmen unter Einsatz von Wärme und/oder Licht einzusetzen. Dabei können sowohl amorphe als polykristalline Schichten erzeugt werden. Dabei können amorphe Schichten nach einer Trocknung durch Konvertierungstemperaturen von bis zu 550 °C erzielt werden, polykristalline Schichten durch Konvertierungstemperaturen höher als 550 °C nach einer Trocknung. In den Beispielen werden Konvertierungszeiten von 30 Minuten (300 °C) beschrieben.

EP 1 085 579 A1 beschreibt Verfahren zur Herstellung von Solarzellen, bei denen flüssige Zusammensetzungen, die Silane enthalten, eingesetzt werden und mit Wärme, Licht und/oder Laserbehandlung konvertiert werden. Die flüssigen Beschichtungszusammensetzungen können ein Lösemittel und eine cyclische Siliciumverbindung der Formel SiₙXₘ (X = H, Hal, n ≥ 5, m = n, 2n-n, 2n) oder eine modifizierte Silanverbindung der Formel SiₐX_{b}Y_{c} (X = H, Hal, Y = B, P, a ≥ 3, c = 1 bis a und b = a bis 2a+c+2) enthalten. Die Umwandlung der Beschichtungszusammensetzungen in Silane kann über einen an einen Trocknungsschritt anschließenden Konvertierungsschritt anschließen. Als typische Trocknungstemperatur wird ein Bereich von 100 - 200 °C angegeben. Auch hier wird ausgeführt, dass erst ab 300 °C ein signifikanter Umsatz zu Siliciumschichten resultiert, dass zwischen 300 °C und 550 °C eine amorphe Schicht resultiert, und dass ab 550 °C polykristalline Schichten resultieren. Konvertierungszeiten werden nicht angegeben.

EP 1 087 428 A1 beschreibt Tintenzusammensetzungen enthaltend einen Silicium-Precursor, mit denen über Druckverfahren ein Siliciumfilm hergestellt werden kann. Bei den dort beschriebenen Silicium-Precursoren handelt es sich um Verbindungen der Formeln (I) SiₙXₘ (mit n ≥ 3, m = n, 2n-2, 2n oder 2n+2 und X = H und/oder Hal) oder (II) SiₐX_{b}Y_{c} (mit X = H und/oder Hal, Y = B, P, a ≥ 3, b = a bis 2a+c+2, c = 1 bis a), die einzeln oder in Mischung eingesetzt werden können. Cyclische Verbindungen der Formel (I) sind bevorzugt. Die Herstellung von Siliciumfilmen kann durch Einsatz von Wärme und/oder Licht erfolgen. Wird Wärme eingesetzt, wird die Konvertierung typischerweise bei Temperaturen von 100 - 800 °C durchgeführt. Dabei können sowohl amorphe als polykristalline Schichten erzeugt werden. Amorphe Schichten können durch Konvertierungstemperaturen von bis zu 550 °C erzielt werden, polykristalline Schichten durch Konvertierungstemperaturen höher als 550 °C. Unterhalb von 300 °C erfolgt keine Konvertierung. Als Konvertierungszeiten werden in den Beispielen Zeiten von 30 Minuten beschrieben.

EP 1 357 154 A1 beschreibt Zusammensetzungen "höherer Silane", die ein Polysilan enthalten, das durch Bestrahlen eines photopolymerisierbaren Silans mit UV-Strahlung herstellbar ist. Bei dem photopolymerisierbaren Silan kann es sich um ein Silan der generellen Formel SiₙXₘ (mit n ≥ 3, m ≥ 4, X = H, Hal) handeln, beispielhaft genannte Verbindungen sind cyclische Silane der Formel SiₙX₂ₙ, bi- bzw. polycyclische Strukturen der Formel SiₙH₂ₙ₋₂ und andere Silane mit einer cyclischen Struktur im Molekül, die eine extreme hohe Reaktivität auf Licht zeigen und effizient photopolymerisieren. Die Zusammensetzungen des "höheren Silans" lassen sich auf einem Substrat durch thermische Zersetzung oder Photozersetzung in einen Siliciumfilm konvertieren. Dazu wird der feuchte Film durch Wärme (typischerweise 100 - 200 °C) getrocknet und dann durch Wärme und/oder Licht konvertiert. Amorphe Filme lassen sich durch thermische Behandlung bei Temperaturen von kleiner als 550 ° erzeugen, bei höheren Temperaturen resultieren polykristalline Filme. In den Beispielen sind Konvertierungszeiten von 10 Minuten (350 °C, 400 °C, 500 °) aufgeführt.

JP 2004-134440 A1 befasst sich mit der Bestrahlung von Silanzusammensetzungen im Kontext einer Siliciumschichtherstellung. Bei den einzusetzenden Silanzusammensetzungen kann es sich (i) um Silane der Formel SiₙRₘ mit n ≥ 11 und m = n bis (2n+2) handeln, wobei R auf = H sein kann, oder um (ii) Silane der Formel SiᵢH₂ᵢ₊₂ (mit i = 2-10), SiⱼH₂ⱼ (mit j = 3-10) oder SiₖHₖ (mit k = 6, 8 oder 10) jeweils in Kombination mit mindestens einem Silan ausgewählt aus der Gruppe bestehend aus Cyclopentasilan, Cyclohexasilan und Silylcyclopentasilan. Die beschriebenen Silane können jeweils ketten-, ring- oder käfigförmig sein. Die Bestrahlungsdauer beträgt zwischen ungefähr 0,1 und 30 Minuten, wobei die Temperatur bei der Bestrahlung zwischen Raumtemperatur und 300 °C liegen kann. Durch diesen Prozess wird ein Siliciumfilmbildner erzeugt, der durch Temperaturen von 100 - 1000 °C, bevorzugt 200 - 850 °C, besonders bevorzugt 300 - 500 °C in einen Siliciumfilm umgewandelt werden kann. Auch hier resultieren polykristalline Siliciumschichten, wenn Konvertierungstemperaturen von größer als 550 °C gewählt werden. Unterhalb von 300 °C erfolgt keine vollständige Filmbildung. In den Beispielen werden Konvertierungszeiten von 30 Minuten (400 °C), 60 Minuten (300 °C, 250 °C).

All diesen beschriebenen Verfahren ist jedoch gemein, dass sie zu schlechten optischen und elektrischen Eigenschaften führen. Als ein Maß für die optischen und elektrischen Eigenschaften einer Siliciumschicht, insbesondere als ein Maß für deren Photoleitfähigkeit, kann der Absorptionskoeffizient α angesehen werden, der im Midgap-Bereich (für aSi bei 1,2 eV) über PDS-Messungen bestimmt werden kann. Dabei gilt generell, dass ein niedriger α-Wert mit guten elektrischen und optischen Eigenschaften und ein hoher α-Wert mit schlechten elektrischen und optischen Eigenschaften korreliert. Dieser α-Wert kann als ein Maß für die Häufigkeit von Zuständen innerhalb der Bandlücke (Mid-Gap-Zuständen) innerhalb der resultierenden Schicht angesehen werden. Zustände innerhalb der Bandlücke (Mid-Gap-Zustände) sind elektronische Zustände innerhalb der Bandlücke, die elektrische Eigenschaften von Halbleitermaterialien, wie z.B. die Photoleitfähigkeit und die Lebensdauer der Ladungsträger, verschlechtern, da sie als Fallen für Elektronen wirken und somit z.B. die Ausbeute an Ladungsträger verringern, die zum Photostrom beitragen. Bei diesen Zuständen handelt es sich oft um nicht abgesättigte Siliciumbindungen (,dangling bonds').

Es ist somit die Aufgabe der vorliegenden Erfindung, ein Flüssigphasen-Verfahren zur Herstellung von Siliciumschichten bereitzustellen, das die angeführten Nachteile des Standes der Technik vermeidet. Insbesondere soll ein Flüssigphasen-Verfahren zur Herstellung von Siliciumschichten bereitgestellt werden, bei dem die eingesetzten Formulierungen stabil sind, das Substrat gut benetzen, und das zu homogenen Siliciumschichten mit besseren elektrischen und optischen Eigenschaften führt. Dabei wäre es weiterhin besonders vorteilhaft, aSi:H-Schichten mit einem niedrigeren Absorptionskoeffizienten α (bestimmbar bei 1,2 eV für aSi:H über PDS-Messungen) herstellen zu können.

Diese Aufgabe wird vorliegend gelöst durch das erfindungsgemäße Flüssigphasen-Verfahren zur thermischen Herstellung von Siliciumschichten auf einem Substrat, bei dem mindestens ein aus mindestens einem Hydridosilan der generischen Formel SiₐH₂ₐ₊₂ (mit a = 3 - 10) herstellbares höheres Silan auf ein Substrat aufgebracht und nachfolgend thermisch in eine im wesentlichen aus Silicium bestehende Schicht konvertiert wird, wobei die thermische Konvertierung des höheren Silans bei einer Temperatur von 500 - 900 °C und einer Konvertierungszeit von ≤ 5 Minuten erfolgt.

Überraschenderweise werden dabei weiterhin Siliciumschichten mit besonders guter Reinheit zugänglich.

Unter einem Flüssigphasen-Verfahren zur thermischen Herstellung von Siliciumschichten ist vorliegend ein Verfahren zu verstehen, bei dem flüssige Edukte (ggf. fungierend als Lösemittel für weitere Additive und/oder Dotierstoffe) oder flüssige Lösungen enthaltend die (selbst flüssigen oder festen) Edukte (und ggf. weitere Additive und/oder Dotierstoffe; letztere insbesondere in Form von Elementverbindungen der III. und V. Hauptgruppe) auf das zu beschichtende Substrat aufgebracht und nachfolgend thermisch (ggf. unterstützt durch elektromagnetische Strahlung) in eine im wesentlichen aus Silicium bestehende Schicht konvertiert werden. Bei dem vorliegend eingesetzten Edukt handelt es sich um mindestens ein aus mindestens einem Hydridosilan der generischen Formel SiₐH₂ₐ₊₂ (mit a = 3 - 10) herstellbares höheres Silan. Hydridosilane der generischen Formel SiₐH₂ₐ₊₂ (mit a = 3 - 10) sind nichtzyklische, d.h. lineare oder verzweigte Hydridosilane. Entsprechende Verfahren zur Herstellung höherer Silane sind dem Fachmann bekannt. Beispielhaft zu nennen sind photochemische, anionische, kationische oder katalytische Polymerisationsprozesse. Von diesen lässt sich bevorzugt der radikalische Polymerisationsprozess durch Bestrahlung mit UV-Strahlung einleiten und durchführen, wobei die Bestrahlungsdauer mit dem entstehenden mittleren Molekulargewicht korreliert. Allen genannten Polymerisationsprozessen ist gemein, dass sie anders als die für cyclische Silane beschriebene ringöffnende Polymerisation dissoziativ verlaufen, d.h. sie führen aufgrund des dissoziativen Reaktionsverlaufs und der zwischenzeitlich entstehenden dissoziierten Zwischenprodukte oder -zustände im Mittel zu höheren Silanen mit einem höheren Verzweigungs- bzw. Quervernetzungsanteil. Erfahrungsgemäß weist ein aus mindestens einem Hydridosilan der generischen Formel SiₐH₂ₐ₊₂ (mit a = 3 - 10) über einen Polymerisationsprozeß herstellbares höheres Silan kein einheitliches Molekulargewicht auf. Unter "einem" höheren Silan im Sinne der vorliegenden Erfindung ist somit ein aus mindestens einem definierten Silan der generischen Formel SiₐH₂ₐ₊₂ (mit a = 3 - 10) über einen dissoziativen Polymerisationsprozess herstellbares Silan zu verstehen, das ein auf dem gewählten Polymerisationsprozess zurückzuführendes im Vergleich zu den eingesetzten Edukten erhöhtes mittleres Molekulargewicht aufweist.

Bevorzugt wird bei dem erfindungsgemäßen Verfahren ein höheres Silan eingesetzt, das ein gewichtsmittleres Molekulargewicht von 330 - 10000 g/mol gemessen über GPC aufweist. Weiter bevorzugt beträgt das gewichtsmittlere Molekulargewicht des höheren Silans 330 - 5000 g/mol, noch weiter bevorzugt 600 - 4000 g/mol gemessen über GPC.

Das mindestens eine höhere Silan kann, wenn es selbst flüssig ist, ohne weitere Lösung in einem Lösemittel auf das Substrat aufgebracht werden. Bevorzugt wird es jedoch gelöst in einem Lösemittel auf das Substrat aufgebracht.

Bevorzugt einsetzbar sind Lösemittel aus der Gruppe bestehend aus linearen, verzweigten oder cyclischen gesättigten, ungesättigten oder aromatischen Kohlenwasserstoffen mit einem bis 12 Kohlenstoffatomen (ggf. partiell oder vollständig halogeniert), Alkoholen, Ethern, Carbonsäuren, Estern, Nitrilen, Aminen, Amiden, Sulfoxiden und Wasser. Besonders bevorzugt sind n-Pentan, n-Hexan, n-Heptan, n-Oktan, n-Dekan, Dodekan, Cyclohexan, Cyclooctan, Cyclodekan, Dicyclopentan, Benzol, Toluol, m-Xylol, p-Xylol, Mesitylen, Indan, Inden, Tetrahydronaphtalin, Decahydronaphtalin, Diethylether, Dipropylether, Ethylenglycoldimethylether, Ethylenglycoldiethylether, Ethylenglycolmethylethylether, Diethylenglycoldimethylether, Diethylenglycoldiethylether, Diethylenglycolmethylethylether, Tetrahydrofuran, p-Dioxan, Acetonitril, Dimethylformamid, Dimethylsulfoxid, Dichlormethan und Chloroform. Besonders gut einsetzbare Lösemittel sind die Kohlenwasserstoffe n-Pentan, n-Hexan, n-Hexan, n-Oktan, n-Dekan, Dodekan, Cyclohexan, Cyclooctan, Cyclodekan, Benzol, Toluol, m-Xylol, p-Xylol, Mesitylen, Indan und Inden.

Wird das mindestens eine höhere Silan in einem Lösemittel eingesetzt, beträgt sein Gewichtsprozentanteil daran bevorzugt mindestens 5 Gew.-% bezogen auf die Gesamtmasse dieser Zusammensetzung. Wird das mindestens eine höhere Silan ohne weitere Lösung in einem Lösemittel auf das Substrat gebracht, beträgt sein Gewichtsprozentanteil, je nachdem, ob es selbst als Lösemittel für weitere Additive und/oder Dotierstoffe dient, bevorzugt zwischen 70 und 100 Gew.-% bezogen auf die Gesamtmasse der Zusammensetzung. Bevorzugt wird somit das mindestens eine höhere Silan in einem Anteil von 5 - 100 Gew.-% bezogen auf die Gesamtmasse der es enthaltenden Zusammensetzung eingesetzt. Besonders dünne Schichten können erzielt werden, wenn Zusammensetzungen mit einem Anteil des mindestens einen höheren Silans von 10-50 Gew-% eingesetzt werden.

Zur Erzielung positiver Schichteigenschaften kann zusammen mit dem mindestens einen aus einem Hydridosilan der generischen Formel SiₐH₂ₐ₊₂ herstellbaren höheren, Silan weiterhin mindestens ein Dotierstoff ausgewählt aus der Gruppe der Verbindungen der Elemente der III. oder V. Hauptgruppe auf das Substrat aufgebracht werden. Entsprechende Verbindungen sind dem Fachmann bekannt. Bevorzugt einsetzbare Dotierstoffe sind Borverbindungen des Typs BHₓR₃₋ₓ mit x = 1 - 3 und R = C₁₋C₁₀-Alkylrest, ungesättigter cyclischer, ggf. ether- oder aminkomplexierter C₂-C₁₀-Alkylrest, Verbindungen der Formeln Si₅H₉BR₂ (R = H, Ph, C₁₋C₁₀-Alkylrest) und Si₄H₉BR₂ (R = H, Ph, C₁₋C₁₀-Alkylrest), roter Phosphor, weißer Phosphor (P₄), Verbindungen der Formel PHₓR₃₋ₓ mit x = 0 - 3 und R = Ph, SiMe₃, C₁₋C₁₀-Alkylrest, und Verbindungen der Formeln P₇(SiR₃)₃ (R = H, Ph, C₁₋C₁₀-Alkylrest), Si₅H₉PR₂ (R = H, Ph, C₁₋C₁₀-Alkylrest) und Si₄H₉PR₂ (R = H, Ph, C₁₋C₁₀-Alkylrest).

Für das erfindungsgemäße Verfahren können eine Vielzahl von Substraten eingesetzt werden. Bevorzugt sind Substrate bestehend aus Glas, Quarzglas, Graphit oder Metall. Weiter bevorzugte Metalle sind Aluminium, Edelstahl, Cr-Stahl, Titan, Chrom bzw. Molybdän. Ferner können Kunststofffolien z.B. aus PEN, PET oder Polyimiden eingesetzt werden. Ebenfalls weiter bevorzugt sind hitzeverträgliche Metallfolien, gegebenenfalls mit einer Schicht, die als Diffusionsbarriere für das Metall dient (z.B. Kohlenstoff, Si₃N₄) und einer leitfähigen Schicht (z.B. TCO, ZnO, SnO₂, ITO - oder Metalle) auf der Diffusionsbarriereschicht. Als Diffusionsbarriere können Al, SiOₓ, AlₓO_{y} sowie Pt, Pd, Rh und Ni verwendet werden. Besonders eignen sich die Oxide von Ti, Al und Zr und die Nitride von Ti und Si.

Ebenfalls bevorzugt kann als Substrat ein Siliciumsubstrat oder eine auf einem hitzeverträglichen Träger befindliche Silicium-, Indiumzinnoxid- (ITO-), ZnO:F oder SnO₂:F- (FTO-)Schicht dienen.

Das Aufbringen des höheren Silans erfolgt bevorzugt über ein Verfahren ausgewählt aus Druckverfahren (insbesondere Flexo/Gravur-Druck, Inkjet-Druck, Offset-Druck, digitalem Offset-Druck und Siebdruck), Sprühverfahren, Rotationsbeschichtungsverfahren ("Spin-coating"), Tauchverfahren ("Dip-coating") und Verfahren ausgewählt aus Meniscus Coating, Slit Coating, Slot-Die Coating, und Curtain Coating.

Nach der Beschichtung und vor der Konvertierung kann das beschichtete Substrat weiterhin getrocknet werden, um ggf. anwesendes Lösemittel zu entfernen. Entsprechende Maßnahmen und Bedingungen hierfür sind dem Fachmann bekannt. Um ausschließlich Lösemittel zu entfernen, sollte im Falle einer thermischen Trocknung die Heiztemperatur nicht mehr als 250°C betragen.

Die Konvertierung des erfindungsgemäßen Verfahrens erfolgt bei Temperaturen von 500 - 900 °C und Konvertierungszeiten von ≤ 5 Minuten. Diese verhältnismäßig schnelle thermische Prozessführung kann zum Beispiel durch den Einsatz einer IR-Lampe, einer Heizplatte, einem Ofen, einer Blitzlampe, einer RTP-Anlage oder einer Mikrowellenanlage (wenn erforderlich, im jeweils vorgeheizten bzw. warmgelaufenen Zustand) erfolgen. Besonders gute optische und elektrische Schichteigenschaften können erzielt werden, wenn die Konvertierungstemperatur 500 - 650 °C beträgt.

Die Konvertierungszeit beträgt bevorzugt 0,1 ms bis 120 s. Zur Erzielung besonders guter optischer und elektrischer Schichteigenschaften sollte eine Konvertierungszeit von 0,1 - 60 s gewählt werden.

Die Güte der resultierenden Schicht wird weiter positiv beeinflusst, wenn die thermische Konvertierung innerhalb eines einzigen thermischen Prozessschrittes erfolgt, d.h. das Substrat wird vorzugsweise nach einer anfänglichen Konvertierung nicht von der Heizquelle entfernt und anschließend wieder erhitzt.

Die Güte der resultierenden Schicht kann weiterhin positiv beeinflusst werden, wenn vor, während oder nach der thermischen Behandlung UV-Strahlung eingestrahlt wird. Dabei sind die positiven Auswirkungen am größten, wenn nach dem Aufbringen des höheren Silans und vor seiner Konvertierung UV-Strahlung eingestrahlt wird. Typische Bestrahlungszeiten liegen dabei zwischen 1 und 20 Minuten.

Bessere Schichten können auch erzielt werden, wenn nach dem Aufbringen des höheren Silans und vor seiner Konvertierung ein verminderter Druck (bis hin zum Vakuum) angelegt wird. Bevorzugte Unterdrücke betragen dabei 1·10⁻³ mbar bis 0,5 bar. Besonders bevorzugt wird dabei das beschichtete Substrat während einer Dauer von 1 bis 20 Minuten bei dem verminderten Druck behandelt.

Beim Herstellen von Mehrfachschichten, wie beispielsweise bei Tandemsolarzellen, ist in der Summe die gleiche Zeit-/Temperaturgrenze (thermisches Budget) einzuhalten. D.h. die Summe aller Temperaturschritte > 500°C sind bevorzugt < 5min zu halten."

Das erfindungsgemäße Verfahren ist besonders gut geeignet zur Herstellung amorpher Siliciumschichten. Mittel und Wege, diese entsprechend zu erzeugen, sind dem Fachmann bekannt. Unter einer amorphen Siliciumschicht ist dabei eine Schicht zu verstehen, deren Ramanspektrum nur einen Peak mit einem Peakmaximum im Bereich von 450 cm⁻¹ - 500 cm⁻¹ und einer FWHM (Full Width Half Maximum) von 50 - 100 cm⁻¹ aufweist. Gegenstand der Erfindung ist somit auch ein Flüssigphasen-Verfahren zur thermischen Herstellung von amorphen Siliciumschichten auf einem Substrat, bei dem mindestens ein aus mindestens einem Hydridosilan der generischen Formel SiₐH₂ₐ₊₂ (mit a = 3 - 10) herstellbares höheres Silan auf ein Substrat aufgebracht und nachfolgend thermisch in eine siliciumhaltige Schicht konvertiert wird, wobei die thermische Konvertierung des höheren Silans bei einer Temperatur von 500 - 900 °C und einer Konvertierungszeit von ≤ 5 min erfolgt. Offenbart wird weiterhin die nach dem erfindungsgemäßen Verfahren herstellbare Siliciumschicht.

Ebenfalls offenbart wird die Verwendung der nach dem erfindungsgemäßen Verfahren herstellbaren Siliciumschichten zur Herstellung elektronischer oder optoelektronischer Bauteilschichten, insbesondere für photovoltaische Anwendungen oder in Transistoren.
Die folgenden Beispiele sollen den Gegenstand der Erfindung weiter ergänzend erläutern.

### Beispiele:

Alle Arbeiten werden unter Ausschluss von O₂ in einer N₂-Glove-Box durchgeführt.

### A. Synthese der höheren Silane

### Beispiel 1 - Material für erfindungsgemäßen Einsatz:

Es werden 3 mL Neopentasilan in einem Wägeglas mit einer UV-Lampe bis zum Erreichen eines gewichtsmittleren Molekulargewichts von ca. M_{w} = 900 g/mol bestrahlt.

### Beispiel 2 - Material für Vergleichsbeispiel:

Es werden 3 mL Cyclopentasilan in einem Wägeglas mit einer UV-Lampe bis zum Erreichen eines gewichtsmittleren Molekulargewichts von ca. M_{w} = 2200 g/mol bestrahlt.

### B. Schichtherstellung

### Beispiel 1:

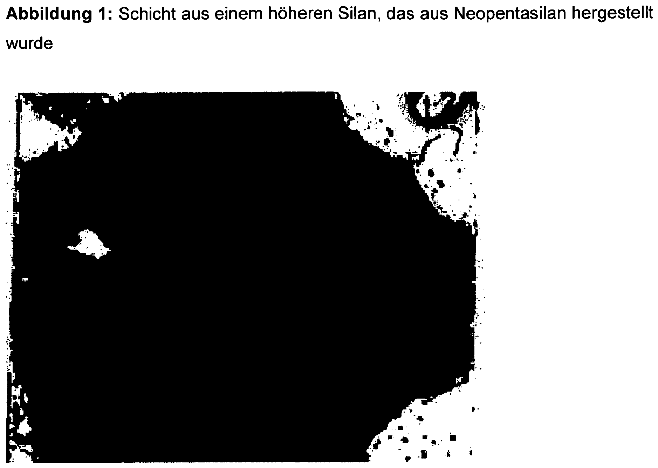

50 µL einer 37,5 gew.-%igen Formulierung aus dem im oben stehenden experimentellen Beispiel 1 erhaltenen oligomerisierten Silan in Cyclooctan werden auf ein 2,5x2,5 cm² großes Glassubstrat aufgetropft und mit 2000 U/min mittels eines Spincoaters gedreht. Der erhaltene Film wird bei 600 °C 20 sec. auf einer Heizplatte ausgehärtet. Eine ca. 130 nm dicke braune Si-Schicht wird erhalten (vgl. Abbildung 1). PDS Daten ergeben einen alpha-Wert bei 1,2 eV von 103 cm⁻¹, Raman-Daten zeigen 100% amorphes aSi:H.

### Vergleichs-Beispiel 1:

50 µL einer 37 gew.-%igen Formulierung aus dem im oben stehenden experimentellen Beispiel 1 erhaltenen oligomerisierten Silan in Cyclooctan werden auf ein 2,5x2,5 cm² großes Glassubstrat aufgetropft und mit 2000 U/min mittels eines Spincoaters gedreht. Der erhaltene Film wird bei 400 °C 10 min auf einer Heizplatte ausgehärtet. Eine ca. 140 nm dicke braune Si-Schicht wird erhalten. PDS Daten ergeben einen alpha-Wert bei 1,2 eV von 120 cm⁻¹, Raman-Daten zeigen 100% amorphes aSi:H.

### Vergleichs-Beispiel 2:

50 µL einer 28,5 gew.-%igen Formulierung aus dem im oben stehenden experimentellen Beispiel 2 erhaltenen oligomerisierten Silan in Cyclooctan werden auf ein 2,5x2,5 cm² großes Glassubstrat aufgetropft und mit 6000 U/min mittels eines Spincoaters gedreht. Der erhaltene Film wird bei 400 °C 10 min auf einer Heizplatte ausgehärtet. Eine ca. 142 nm dicke braune Si-Schicht wird erhalten. PDS Daten ergeben einen alpha-Wert bei 1,2 eV von 172 cm⁻¹, Raman-Daten zeigen 100% amorphes aSi:H.

### Vergleichs-Beispiel 3:

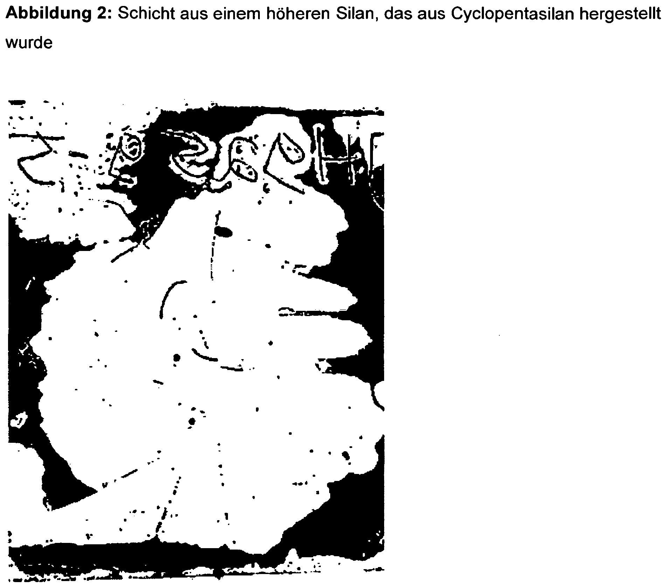

Es werden 3 mL Cyclopentasilan in einem Wägeglas mit einer UV-Lampe bis zum Erreichen eines gewichtsmittleren Molekulargewichts von ca. M_{w} = 3100 g/mol bestrahlt. 50 µL einer 37,5 gew.-%igen Formulierung aus dem erhaltenen oligomerisierten Silan in Cyclooctan werden auf ein 2,5x2,5 cm² großes Glassubstrat aufgetropft und mit 2500 U/min mittels eines Spincoaters gedreht. Der erhaltene Film wird bei 500 °C 60 sec auf einer Heizplatte ausgehärtet (vgl. Abbildung 2).

## Patentansprüche

1. Flüssigphasen-Verfahren zur thermischen Herstellung von Siliciumschichten auf einem Substrat, bei dem mindestens ein aus mindestens einem Hydridosilan der generischen Formel SiₐH₂ₐ₊₂ (mit a = 3 - 10) herstellbares höheres Silan auf ein Substrat aufgebracht und nachfolgend thermisch in eine im wesentlichen aus Silicium bestehende Schicht konvertiert wird,
**dadurch gekennzeichnet, dass**
die thermische Konvertierung des höheren Silans
- bei einer Temperatur von 500 - 900 °C
- und einer Konvertierungszeit von ≤ 5 Minuten erfolgt.

2. Verfahren nach Anspruch 1,
**dadurch gekennzeichnet, dass**
das mindestens eine höhere Silan ein gewichtsmittleres Molekulargewicht von 330
- 10.000 g/mol aufweist.

3. Verfahren nach Anspruch 1 oder 2,
**dadurch gekennzeichnet, dass**
das mindestens eine höhere Silan gelöst in einem Lösemittel auf das Substrat aufgebracht wird.

4. Verfahren nach einem der vorhergehenden Ansprüche,
**dadurch gekennzeichnet, dass**
das mindestens eine höhere Silan in einem Anteil von 5 - 100 Gew.-% bezogen auf die Gesamtmasse der es enthaltenden Zusammensetzung eingesetzt wird.

5. Verfahren nach einem der vorhergehenden Ansprüche,
**dadurch gekennzeichnet, dass**
das mindestens eine höhere Silan zusammen mit mindestens einem Dotierstoff ausgewählt aus der Gruppe an Verbindungen der Elemente der III. oder V. Hauptgruppe auf das Substrat aufgebracht wird.

6. Verfahren nach einem der vorhergehenden Ansprüche,
**dadurch gekennzeichnet, dass**
das Substrat aus Glas, Quarzglas, Graphit, Metall, Kunststoff oder Silicium oder aus einer auf einem hitzeverträglichen Träger befindlichen Silicium-, Indiumzinnoxid-, ZnO:F- oder SnO₂:F-Schicht besteht.

7. Verfahren nach einem der vorhergehenden Ansprüche,
**dadurch gekennzeichnet, dass**
das Aufbringen des mindestens einen höheren Silans über ein Verfahren ausgewählt aus Druckverfahren, Sprühverfahren, Rotationsbeschichtungsverfahren, Tauchverfahren, Meniscus Coating, Slit Coating, Slot-Die Coating, und Curtain Coating erfolgt.

8. Verfahren nach einem der vorhergehenden Ansprüche,
**dadurch gekennzeichnet, dass**
die thermische Konvertierung bei Temperaturen von 500 - 650 °C erfolgt..

9. Verfahren nach einem der vorhergehenden Ansprüche,
**dadurch gekennzeichnet, dass**
die Konvertierungszeit 0,1 ms bis 120 s, besonders bevorzugt 0,1 - 60 s beträgt.

10. Verfahren nach einem der vorhergehenden Ansprüche,
**dadurch gekennzeichnet, dass**
die thermische Konvertierung innerhalb eines einzigen thermischen Prozessschrittes erfolgt.

11. Verfahren nach einem der vorhergehenden Ansprüche,
**dadurch gekennzeichnet, dass**
vor, während oder nach der thermischen Behandlung UV-Strahlung eingestrahlt wird.

12. Verfahren nach einem der vorhergehenden Ansprüche,
**dadurch gekennzeichnet, dass**
nach dem Aufbringen des höheren Silans und vor seiner Konvertierung ein verminderter Druck angelegt wird.

## Claims

1. Liquid phase process for thermal production of silicon layers on a substrate, in which at least one higher silane preparable from at least one hydridosilane of the generic formula SiₐH₂ₐ₊₂ (where a = 3-10) is applied to a substrate and then converted thermally to a layer comprising essentially silicon,
**characterized in that**
the higher silane is thermally converted
- at a temperature of 500-900°C
- with a conversion time of ≤ 5 minutes.

2. Process according to Claim 1,
**characterized in that**
the at least one higher silane has a weight-average molecular weight of 330-10 000 g/mol.

3. Process according to Claim 1 or 2,
**characterized in that**
the at least one higher silane is applied to the substrate dissolved in a solvent.

4. Process according to any one of the preceding claims,
**characterized in that**
the at least one higher silane is used in a proportion of 5-100% by weight, based on the total mass of the composition containing it.

5. Process according to any one of the preceding claims,
**characterized in that**
the at least one higher silane is applied to the substrate together with at least one dopant selected from the group of compounds of the elements of main group III or V.

6. Process according to any one of the preceding claims,
**characterized in that**
the substrate comprises glass, quartz glass, graphite, metal, plastic or silicon, or a silicon, indium tin oxide, ZnO:F or SnO₂:F layer present on a heat-compatible carrier.

7. Process according to any one of the preceding claims,
**characterized in that**
the at least one higher silane is applied by means of a process selected from printing processes, spraying processes, rotary coating processes, dipping processes, meniscus coating, slit coating, slot-die coating and curtain coating.

8. Process according to any one of the preceding claims,
**characterized in that**
the thermal conversion is effected at temperatures of 500-650°C.

9. Process according to any one of the preceding claims,
**characterized in that**
the conversion time is 0.1 ms to 120 s, more preferably 0.1-60 s.

10. Process according to any one of the preceding claims,
**characterized in that**
the thermal conversion is effected within a single thermal process step.

11. Process according to any one of the preceding claims,
**characterized in that**
UV radiation is injected before, during or after the thermal treatment.

12. Process according to any one of the preceding claims,
**characterized in that**
a reduced pressure is applied after the application of the higher silane and before the conversion thereof.

## Revendications

1. Procédé en phase liquide pour la fabrication thermique de couches de silicium sur un substrat, selon lequel au moins un silane supérieur fabricable à partir d'au moins un hydridosilane de formule générique SiₐH₂ₐ₊₂ (avec a = 3 à 10) est appliqué sur un substrat, puis converti thermiquement en une couche essentiellement constituée de silicium,
**caractérisé en ce que**
la conversion thermique du silicium supérieur a lieu
- à une température de 500 à 900 °C
- et avec un temps de conversion ≤ 5 minutes.

2. Procédé selon la revendication 1, **caractérisé en ce que** ledit au moins un silane supérieur présente un poids moléculaire moyen en poids de 330 à 10 000 g/mol.

3. Procédé selon la revendication 1 ou 2, **caractérisé en ce que** ledit au moins un silane supérieur est appliqué sur le substrat dissous dans un solvant.

4. Procédé selon l'une quelconque des revendications précédentes, **caractérisé en ce que** ledit au moins un silane supérieur est utilisé en une proportion de 5 à 100 % en poids, par rapport à la masse totale de la composition qui le contient.

5. Procédé selon l'une quelconque des revendications précédentes, **caractérisé en ce que** ledit au moins un silane supérieur est appliqué sur le substrat conjointement avec au moins un dopant choisi dans le groupe des composés des éléments du groupe principal III ou V.

6. Procédé selon l'une quelconque des revendications précédentes, **caractérisé en ce que** le substrat est constitué de verre, de verre de quartz, de graphite, de métal, de plastique ou de silicium ou d'une couche de silicium, d'oxyde d'indium et d'étain, de ZnO:F ou de SnO₂:F se trouvant sur un support tolérant la chaleur.

7. Procédé selon l'une quelconque des revendications précédentes, **caractérisé en ce que** l'application dudit au moins un silane supérieur a lieu par un procédé choisi parmi les procédés d'impression, les procédés de pulvérisation, les procédés de revêtement par rotation, les procédés d'immersion, le couchage à ménisque, le couchage à fente, le couchage par filière droite plate et l'application au rideau.

8. Procédé selon l'une quelconque des revendications précédentes, **caractérisé en ce que** la conversion thermique a lieu à des températures de 500 à 650 °C.

9. Procédé selon l'une quelconque des revendications précédentes, **caractérisé en ce que** le temps de conversion est de 0,1 ms à 120 s, de manière particulièrement préférée de 0,1 à 60 s.

10. Procédé selon l'une quelconque des revendications précédentes, **caractérisé en ce que** la conversion thermique a lieu en une étape de procédé thermique individuelle.

11. Procédé selon l'une quelconque des revendications précédentes, **caractérisé en ce qu'**une exposition à un rayonnement UV a lieu avant, pendant ou après le traitement thermique.

12. Procédé selon l'une quelconque des revendications précédentes, **caractérisé en ce qu'**une pression réduite est appliquée après l'application du silane supérieur et avant sa conversion.
